(19) Europäisches Patentamt

European Patent Office

Office européen des brevets

(11) Veröffentlichungsnummer: **0 116 162**
**B1**

(12) **EUROPÄISCHE PATENTSCHRIFT**

(45) Veröffentlichungstag der Patentschrift:
03.08.88

(51) Int. Cl.⁴: **H 05 K 7/12, H 05 K 7/10**

(21) Anmeldenummer: **83112925.9**

(22) Anmeldetag: **21.12.83**

(54) **Einrichtung für die Steckmontage eines elektrischen Schaltungsträgers auf einem elektrischen Gerät oder dergleichen sowie Verfahren zur Herstellung der Einrichtung.**

(30) Priorität: **11.01.83 DE 3300706**

(43) Veröffentlichungstag der Anmeldung:
**22.08.84 Patentblatt 84/34**

(45) Bekanntmachung des Hinweises auf die Patenterteilung:
**03.08.88 Patentblatt 88/31**

(84) Benannte Vertragsstaaten:
**DE FR GB IT SE**

(56) Entgegenhaltungen:
**EP - A - 0 033 472**
**FR - A - 2 054 838**
**FR - A - 2 288 394**
**GB - A - 2 095 923**
**US - A - 4 209 216**

**MODERN PLASTICS, Band 43, Nr. 5, Januar 1966, Seite 128, Lausanne, CH; "Lid-flipping polypropylene socket protects electronic modules, expedites changes"**

(73) Patentinhaber: **Nixdorf Computer Aktiengesellschaft, Fürstenallee 7, D-4790 Paderborn (DE)**

(72) Erfinder: **Tewes, Udo, Eiser Kirchstrasse 41, D-4790 Paderborn (DE)**
Erfinder: **Roeschlein, Rolf, Karl-Arnold-Strasse 26, D-4790 Paderborn (DE)**

(74) Vertreter: **Patentanwälte Schaumburg & Thoenes, Mauerkircherstrasse 31 Postfach 86 07 48, D-8000 München 80 (DE)**

## Beschreibung

Die Erfindung betrifft eine Einrichtung gemäss dem Oberbegriff des Anspruches 1 sowie ein Verfahren zur Herstellung und zur Montage einzelner Komponenten der Einrichtung.

Elektrische Schaltungsträger kleiner Abmessungen, insbesondere IC-Bausteine werden wegen ihres empfindlichen Aufbaus und ihrer geringen Abmessungen im allgemeinen vom Hersteller montiert bzw. vergossen; die feinen und empfindlichen Anschlussdrähte werden mit am Schaltungsträger ausgebildeten Kontaktfüssen verbunden. In dieser Form, in der z.B. die empfindlichen IC-Bausteine selbst von aussen nicht mehr zugänglich sind, kommen diese in den Handel. Die Formen der Schaltungsträger, insbesondere deren Abmessungen, Anzahl und Abstand der Kontaktfüsse usw., sind weitgehend genormt.

Der Schaltungsträger kann dann in am elektrischen Gerät ausgebildete, der Anordnung der Kontaktfüsse entsprechend angeordnete Aufnahmen gesteckt werden, wo er mit den Elementen einer elektrischen Schaltung, mit welcher er zusammenwirken soll, in Verbindung tritt. Die Kontaktfüsse werden im allgemeinen mit den Anschlussstellen verlötet.

Um diese sehr mühsame und wegen der entstehenden Lötwärme besonders für die IC-Bausteine nachteilige Montage zu erleichtern, ist es auch schon bekannt, auf dem elektrischen Gerät zunächst einen Sockel aufzusetzen, welcher mit entsprechend den Kontaktfüssen des Schaltungsträgers angeordneten Kontaktelementen versehen ist, so dass er in die Aufnahmen des Gerätes passt. Da der Sockel keine empfindlichen elektronischen Bausteine trägt, kann er gefahrlos mit den Anschlussstellen verlötet werden. Auf diesen Sockel wird z.B. ein IC-Träger aufgesetzt, wobei dessen Kontaktfüsse mit den Kontaktelementen des Sockels in Verbindung treten. Zum Schutz des IC-Trägers sowie um diesen auf dem Sockel festzuhalten, ist eine über den IC-Träger stülpbare Haube vorgesehen (AMP-Prospekt «Interconnection Packaging Devices and Accessories», 1974, Nr. 14, Seiten 120 und 121).

Bei der bekannten Lösung ist die Montage und insbesondere die Handmontage der gesamten Einrichtung sehr umständlich und mit Unsicherheiten bezüglich der korrekten Anordnung des IC-Trägers behaftet. Die IC-Träger sind im allgemeinen bezüglich einer Längsachse symmetrisch ausgebildet. Sie können deshalb grundsätzlich in zwei um 180° verdrehten Lagen an die im elektrischen Gerät ausgebildeten Aufnahmen eingesetzt werden. Die richtige Lage ist nur aus einer am IC-Träger angeordneten Markierung oder dgl. zu erkennen. Ebenso lassen sich die IC-Träger bei der bekannten Lösung auf dem Sockel in zwei verschiedenen, um 180° verdrehten Lagen aufsetzen, wenn nicht sowohl am Sockel als auch am IC-Träger besondere Codierungsmittel angeordnet werden, welche nur noch eine Montagestellung des IC-Trägers auf dem Sockel zulassen.

Derartige Codierungsmittel sind an den genormten IC-Trägern jedoch nicht vorgesehen.

Bei der Montage der Einrichtung wird zunächst der IC-Träger auf den vorher mit dem elektrischen Gerät verbundenen Sockel aufgesetzt, wobei vor allem bei schlecht zugänglichen und schlecht einsehbaren Montageorten die korrekte Lage des IC-Trägers nicht sichergestellt ist. Der IC-Träger muss sodann auf die federnden Kontaktelemente des Sockels gedrückt und auf diesem festgehalten werden, während die Haube über den IC-Träger gestülpt und auf den Sockel aufgesetzt wird, was vor allem bei schlecht zugänglichen Montageorten ein ganz besonderes Geschick des Verarbeiters erfordert.

Es ist bereits eine Einrichtung bekannt, bei welcher der Schaltungsträger vor seiner Montage auf dem Gerät in vorbestimmter Lage in eine Haube einsetzbar und fixierbar ist und bei welcher ausserdem Haltemittel vorgesehen sind, mit denen dann die Haube nur in vorbestimmter Ausrichtung zum Sockel fixiert werden kann, so dass auch eine lagerichtige Montage des Geräteträgers zum Sokkel sichergestellt ist (EP-A 0 033 472).

Es ist die Aufgabe der Erfindung, eine Einrichtung der gattungsgemässen Art zu schaffen, bei welcher der Schaltungsträger besser als bisher gegen mechanische und elektrische Beschädigung geschützt und von Steckkräften freigehalten ist.

Diese Aufgabe ist erfindungsgemäss durch die im Kennzeichen des Anspruchs 1 enthaltenen Merkmale gelöst.

Der Zwischenkontaktträger kann ohne besondere Schwierigkeiten z.B. an bestimmten Montageplätzen mit dem Schaltungsträger verbunden und mit diesem zusammen in die Haube eingesetzt werden. Der Schaltungsträger ist dann zwischen der Haube und dem Zwischenkontaktträger geschützt, so dass er und vor allem seine empfindlichen Kontaktfüsse nicht mehr berührt und beschädigt werden können. Vor allem werden die Kontaktfüsse nicht mehr bei jeder Montage bzw. Demontage in Aufnahmen gesteckt bzw. aus den Aufnahmen gezogen; auf diese Weise bleiben sie von Steckkräften verschont und eine dadurch verursachte Beschädigung ist ausgeschlossen. Die Kontaktlamellen des Zwischenkontaktträgers können in idealer Weise so gestaltet und so am Zwischenkontaktträger angeordnet werden, dass die Gefahr von Beschädigungen bzw. der Herstellung falscher Kontaktverbindungen beim Aufsetzen der aus der Haube, dem Schaltungsträger sowie dem Zwischenkontaktträger gebildeten Baugruppe auf den Sockel ausgeschlossen werden kann, wie weiter unten genauer beschrieben wird.

Für die meist verwendeten Schaltungsträger mit in Steckrichtung ausgerichteten Kontaktfüssen ist erfindungsgemäss vorgesehen, dass an der in Steckrichtung unteren Seite des Schaltungsträgers ein Zwischenkontaktträger mit auf dessen Unterseite aufliegenden, über seine Seitenränder hinausragenden Kontaktlamellen befestigbar ist, wobei die diese Seitenränder übergreifenden Kontaktfüsse des Schaltungsträgers jeweils mit zugeordneten Kontaktlamellen in elektrisch leitende Verbindung treten. Die Kontaktlamellen können wesentlich besser als die Kontaktfüsse des Schaltungsträgers für eine grossflächige Berührung bzw. eine Berührung in mehreren Berührungspunkten mit den Kontaktelementen des Sockels ausgebildet werden. Um die Bedingung zu erfüllen, dass im gesamten Aufbau der erfindungsgemässen Einrichtung zwischen den Kontaktfüssen des Schaltungsträgers und den Aufnahmen des elektrischen Gerätes jeweils nur einmal Berührungskontakt auftritt, kann zwischen den Kontaktfüssen und den Kontaktlamellen eine Lötverbindung vorgesehen sein. Die Kontaktlamellen des Zwischenkontaktträgers treten beim Aufsetzen der aus Haube, Schaltungsträger und Zwischenkontaktträger gebildeten Baugruppe (Sub-Modul) auf den Sockel mit zugeordneten, auf die Oberseite des Sockels geführten Kontaktelementen in elektrisch leitende Berührung.

Nach einem Merkmal der Erfindung weist die Haube auf ihrer Oberseite eine Kühlöffnung auf, in der türflügelartig zwischen einer diese Öffnung teilweise abdeckenden Schliessstellung und einer die Öffnung freigebenden Öffnungsstellung zumindest ein nach aussen verschwenkbarer Schwenkflügel angeordnet ist. Die Abdeckung geht so weit, dass einerseits der darunter angeordnete Schaltungsträger gegen Beschädigungen geschützt ist, dass andererseits aber in Verbindung mit anderen in der Haube vorgesehenen Öffnungen Kühlluft zirkulieren kann. In der Öffnungsstellung kann der Schwenkflügel als Handgriff zum Handhaben des Sub-Moduls dienen.

In weiterer Ausgestaltung der Erfindung sind zwei nebeneinander angeordnete Schwenkflügel vorgesehen, welche an ihren benachbarten Seitenkanten schwenkbar gelagert sind, wobei sie in ihrer Öffnungsstellung flach aneinanderliegend handgriffartig von der Oberseite der Haube abstehen.

Nach einem weiteren Merkmal der Erfindung ist vorgesehen, dass die Schwenkflügel zumindest in ihrer Schliessstellung in wärmeleitendem Kontakt mit dem Schaltungsträger stehen, dass sie aus einem Material mit hoher Wärmeleitfähigkeit bestehen und dass sie an den in ihrer Schliessstellung nach aussen gerichteten Oberflächen mit Kühlrippen oder dgl. versehen sind. Auf diese Weise kann die Wärmeabfuhr vor allem von hochbelasteten Leistungs-ICs noch beträchtlich verbessert werden.

Für Schaltungsträger mit zwei parallelen Reihen von Kontaktfüssen (z.B. dual in line) ist vorgesehen, dass an der Unterseite des Zwischenkontaktträgers zwei nebeneinander angeordnete, parallel zu den Kontaktfussreihen verlaufende Reihen von jeweils zueinander parallelen Kontaktlamellem angeordnet sind, welche an ihren über die Seitenränder des Zwischenkontaktträgers ragenden Kontaktenden Öffnungen zur Aufnahme der Kontaktfüsse aufweisen. Entsprechend sind am Sockel zwei nebeneinander angeordnete Reihen von zueinander parallelen, den zugeordneten Kontaktlamellen des Zwischenkontaktträgers jeweils gegenüberliegende Kontaktelementen angeordnet, welche sich jeweils aus einem auf der Oberseite des Sockels angeordneten Bügelteil und einem über die Seitenkanten des Sockels nach unten gebogenen, in Steckrichtung ausgerichteten Fussteil zusammensetzen. Die Fussteile werden jeweils von den Aufnahmen des elektrischen Gerätes aufgenommen, während die Bügelteile die Verbindung mit den Kontaktlamellen des Zwischenkontaktträgers herstellen, welche ihrerseits wiederum mit den Kontaktfüssen des Schaltungsträgers in Verbindung stehen.

Am Zwischenkontaktträger sind jeweils zwischen den Kontaktlamellen und am Sockel jeweils zwischen den Bügelteilen Rippen ausgebildet, welche komplementäre, formschlüssig ineinandergreifende Profile bilden. Diese Profile gewährleisten, dass der Zwischenkontaktträger und der Sockel schon vor der Kontaktnahme der Kontaktlamellen mit den Kontaktelementen lagerichtig zueinander ausgerichtet werden, so dass eine Fehlsteckung nicht möglich ist.

Der Bügelteil der Kontaktelemente des Sockels ist etwa Z-förmig mit einem auf der Oberseite des Sockels aufliegenden unteren Basisschenkel sowie einem über den Verbindungsschenkel federnd damit verbundenen oberen Kontaktschenkel ausgebildet. Auf diese Weise wird der Bügelteil im montierten Zustand der Einrichtung stets federnd gegen die zugeordnete Kontaktlamelle gedrückt, womit ein einwandfreier Kontakt gewährleistet ist. Das freie Ende des Basisschenkels weist zum Seitenrand des Sockels hin und geht in den in Steckrichtung zeigenden Fussteil des Kontaktelementes über, wie weiter unten genauer beschrieben wird.

Die zusammensetzbaren Einzelteile der Einrichtung, insbesondere der Zwischenkontaktträger und der Sockel, können in einer nur eine bestimmte gegenseitige Montagelage erlaubenden Weise profiliert sein. In einer bevorzugten Ausgestaltung der Erfindung ist jedoch vorgesehen, dass der Sockel sowie der Zwischenkontaktträger jeweils eine mehrere gegenseitige Montagelagen, beispielsweise um 180° verdreht, erlaubende Form aufweisen und dass an ihnen jeweils bestimmte Montagelagen blockierende Codiernocken befestigbar sind. Wenn es auf eine bestimmte Montagelage nicht ankommt, können die Codiernocken fortgelassen werden.

Zur Herstellung eines Sockels gemäss der vorliegenden Erfindung mit zwei nebeneinander angeordneten Reihen von Kontaktelementen wird ein Verfahren vorgeschlagen, nach welchem die mit ihren Fussteilen an einem gemeinsamen Haltesteg befestigten Kontaktelemente einer Reihe jeweils gemeinsam auf die Oberseite des Sockels aufgeschoben und anschliessend vom Haltesteg abgetrennt werden. Zur Herstellung des diesem Sockel entsprechenden Zwischenkontaktträgers wird erfindungsgemäss ein Verfahren vorgeschlagen, nach welchem die mit ihren Kontaktenden an einem gemeinsamen Haltesteg befestigten und mit den den Kontaktenden abgewandten Enden miteinander verbundenen Kontaktlamellen beider Reihen gemeinsam auf die Unterseite des Zwischenkontaktträgers aufgedrückt werden und dass anschliessend die Kontaktlamellen der beiden Reihen voneinander und von den Haltestegen getrennt werden. Diese Verfahren lassen sich sehr gut durch automatische Montageeinrichtungen durchführen.

Für die Montage des Schaltungsträgers auf den Zwischenkontaktträger ist vorgesehen, dass der Schaltungsträger unter Einführung seiner Kontaktfüsse in die zugeordneten Öffnungen der Kontaktlamellen auf den Zwischenkontaktträger aufgesetzt wird und dass anschliessend die Verbindungsstellen zwischen Kontaktfüssen und Kontaktlamellen durch ein Lötbad geführt werden.

Weitere Vorteile sowie Merkmale der Erfindung ergeben sich aus den Patentansprüchen, der Zeichnung sowie der Zeichnungsbeschreibung. Ein Ausführungsbeispiel der Erfindung für einen IC-Träger ist in der Zeichnung dargestellt und im folgenden näher beschrieben. Es zeigen:

Fig. 1a bis 1d eine Haube, einen IC-Träger, einen Zwischenkontaktträger sowie einen Sockel in einer perspektivischen Darstellung vor ihrem Zusammenbau,

Fig. 2 einen teilweisen Querschnitt durch eine zusammengebaute Einrichtung entsprechend Fig. 1,

Fig. 3 eine Einzelheit des Zwischenkontaktträgers sowie des Sockels gemäss Fig. 1c und 1d in vergrösserter Darstellung,

Fig. 4 mehrere durch einen Verbindungssteg miteinander verbundene Kontaktelemente für einen Sockel gemäss Fig. 1d,

Fig. 5 mehrere durch Verbindungsstege miteinander verbundene Kontaktlamellen für einen Zwischenkontaktträger gemäss Fig. 1c;

Fig. 6 einen Querschnitt durch eine Zwischenkontaktträger mit aufgesetztem IC-Träger gemäss den Fig. 1c und 1b während eines Lötverfahrens.

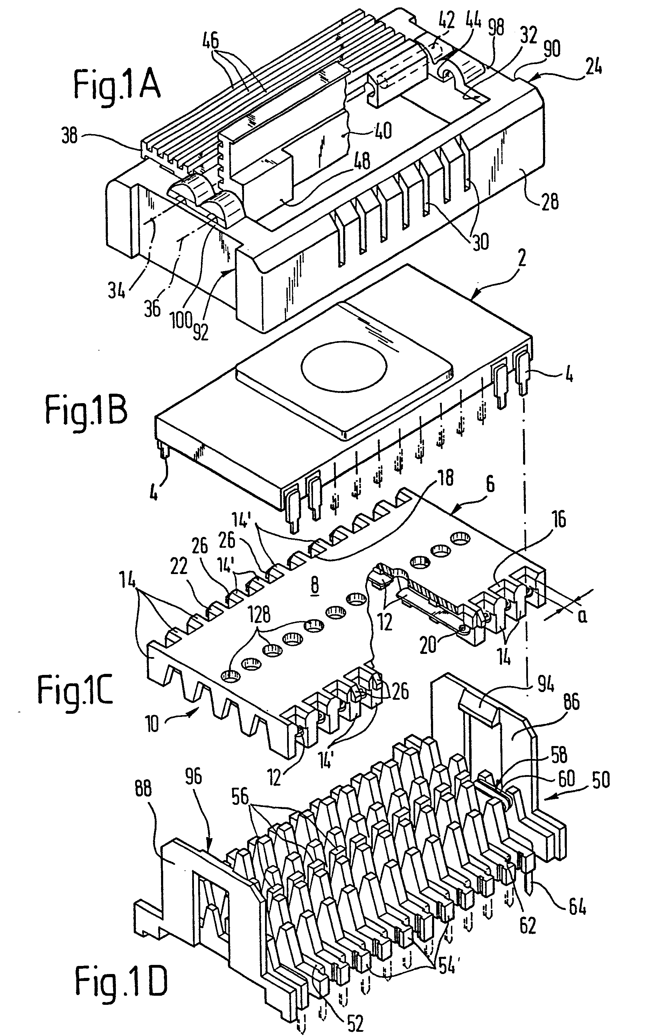

Fig. 1 zeigt die einzelnen Komponenten der Einrichtung vor ihrem Zusammenbau, und zwar stellt Fig. 1a die Haube, Fig. 1b den IC-Träger, Fig. 1c den Zwischenkontaktträger und Fig. 1d den Sockel dar. Der IC-Träger 2 ist vom dual-in-line-Typ, d.h. er besitzt zwei Reihen von Kontaktfüssen 4, welche mit den Ausgängen des nicht näher dargestellten IC-Bausteins verbunden sind. Der IC-Träger 2 ist von üblichem Aufbau und braucht deshalb nicht mehr beschrieben zu werden.

Fig. 1c zeigt einen Zwischenkontaktträger 6, welcher aus einem etwa plattenartigen Grundkörper 8 aus einem isolierenden Material, beispielsweise Kunststoff, besteht, welcher auf seiner Unterseite 10 zur Aufnahme mehrerer Kontaktlamellen 12 eingerichtet ist. Wie Fig. 1c erkennen lässt, sind zwei nebeneinander angeordnete Reihen von zueinander parallelen Kontaktlamellen 12 vorgesehen, so dass jedem Kontaktfuss 4 des IC-Trägers 2 je eine Kontaktlamelle 12 des Zwischenkontaktträgers 6 zugeordnet ist. Die Kontaktlamellen 12 liegen jeweils zwischen an der Unterseite des Zwischenkontaktträgers 6 ausgebildeten Rippen 14, welche quer zu dessen Längsausdehnung verlaufen und die einzelnen Kontaktlamellen elektrisch voneinander isolieren. Die Kontaktlamellen 12 weisen an ihren über die Seitenränder 16, 18 des Zwischenkontaktträgers 6 hinausragenden Enden jeweils Öffnungen 20 auf, welche zur Aufnahme der Kontaktfüsse 4 des IC-Trägers 2 dienen. Die Kontaktlamellen werden durch an ihnen ausgebildete widerhakenartige Profile, die sich in das Material des Zwischenkontaktträgers 6 eingraben, an diesem festgehalten, wie weiter unten noch genauer erläutert wird. Jede der Rippen 14 ist etwa sägezahnartig profiliert, wie insbesondere die erste, stirnseitige Rippe in Fig. 1c erkennen lässt. Diese Profilierung dient zur lagerichtigen Zentrierung des Zwischenkontaktträgers 6 auf dem Sockel.

In einem ersten Montageschritt wird der IC-Träger 2 auf den Zwischenkontaktträger 6 aufgesetzt, wobei jeder Kontaktfuss 4 in die Öffnung 20 der zugeordneten Kontaktlamelle 12 eingreift. Zur Erleichterung der Einführung der Kontaktfüsse 4 in die zwischen den Rippen 14 verbleibenden Zwischenräume weisen die Rippen 14 an ihrer Oberseite jeweils Abschrägungen 22 auf. Die Weite a des die Kontaktfüsse 4 aufnehmenden Zwischenraumes ist so bemessen, dass die Kontaktfüsse 4 mit leichter Presspassung zwischen den Rippen festgehalten werden, so dass eine weitere Fixierung des IC-Trägers 2 auf dem Zwischenkontaktträger 6 nicht erforderlich ist. Nach dem Zusammenbau werden die Verbindungen zwischen den Kontaktfüssen 4 und den Kontaktlamellen 12 verlötet, wie weiter unten beschrieben wird.

Der mit dem Zwischenkontaktträger 6 vereinigte IC-Träger 2 wird von unten in die ebenfalls aus Kunststoff bestehende Haube 24 eingesetzt. Dabei greifen mehrere an den mittleren Rippen 14' ausgebildete Haltenasen 26 in an den Seitenwänden 28 der Haube 24 ausgebildete Schlitze 30 ein. Beim Einsetzen des Zwischenkontaktträgers 6 in die Haube 24 können die Seitenwände 28 zunächst elastisch ausweichen, bis die Haltenasen 26 in die Schlitze 30 einschnappen und ein Herausgleiten des Zwischenkontaktträgers 6 aus der Haube verhindern. Die Schlitze 30 dienen gleichzeitig für die Kühlluftzufuhr ins Innere der Haube 24. Auf der Oberseite der Haube 24 ist eine Kühlöffnung 32 ausgebildet. In dieser sind zwei um ihre Achsen 34 bzw. 36 schwenkbare Schwenkflügel 38, 40 angeordnet. Für die Lagerung dieser Schwenkflügel dienen an diesen befestigte Scharnierbolzen 42, welche in Scharnieraufnahmen 44 der Haube 24 eingreifen, wie der besseren Übersichtlichkeit wegen jeweils nur einmal dargestellt wurde. Die Schwenkflügel können jeweils zwischen einer Öffnungsstellung (siehe Schwenkflügel 40) sowie einer Schliessstellung (siehe Schwenkflügel 38) verschwenkt werden. In ihrer Schliessstellung decken sie die Kühlöffnung 32 weitgehend ab, so dass der darunter befindliche IC-Träger 2 gegen Berührung und Beschädigung geschützt ist. Zwischen den Schwenkflügeln 38, 40 bleibt jedoch ein Spalt offen, welcher der Austritt der durch die Schlitze 30 eintretenden Kühlluft erlaubt. Die Schwenkflügel 38, 40 sind vorzugsweise aus einem gut wärmeleitenden Material, z.B. Aluminium, hergestellt und auf der in ihrer Schliessstellung nach aussen gerichteten Oberfläche mit Kühlrippen 46 versehen. Auf der Unterseite der Schwenkflügel 38, 40 sind jeweils Kontaktflächen 48 ausgebildet, welche bei geschlossenen Schwenkflügeln auf der Oberfläche des IC-Trägers 2 aufliegen und auf diese Weise die im IC-Träger 2 entstehende Wärme nach aussen abführen können. Wenn beide Schwenkflügel 38, 40 ihre Öffnungsstellung einnehmen, liegen sie mit ihren Oberseiten flach aneinander und bilden dann einen Handgriff, an welchem der gesamte aus IC-Träger 2, Zwischenkontaktträger 6 sowie Haube 24 bestehende Sub-Modul erfasst und gehandhabt werden kann.

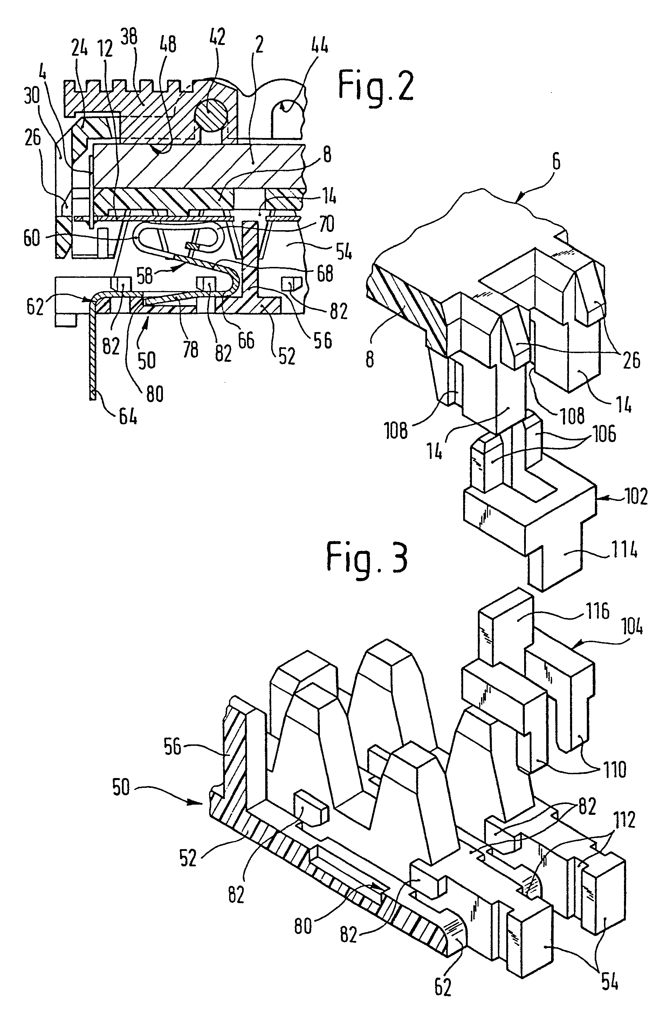

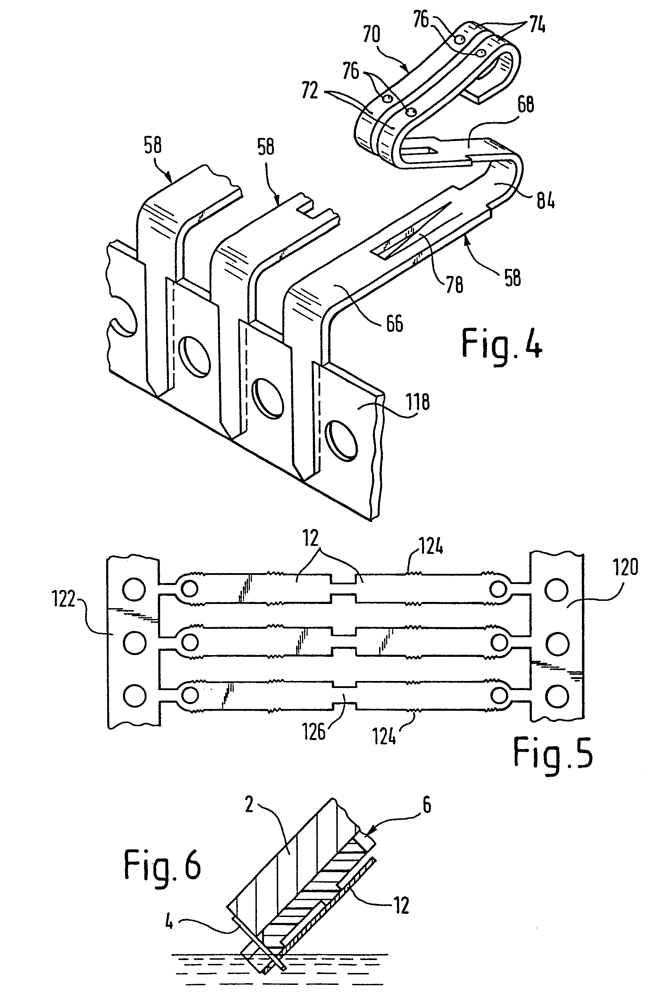

Der in Fig. 1d dargestellte Sockel 50 besteht ebenfalls aus einem elektrisch isolierenden Material, beispielsweise Kunststoff. Der Sockel umfasst im wesentlichen einen flachen Grundkörper 52 (siehe auch Fig. 2), auf dessen Oberseite ebenfalls mehrere quer zur Längsausdehnung des Sockels 50 verlaufende Rippen 54 ausgebildet sind. Die Rippen 54 sind ebenfalls sägezahnartig profiliert, wobei das Profil der Rippen 54 komplementär zum Profil der Rippen 14 ausgebildet ist. Wenn der Zwischenkontaktträger 6 auf den Sockel 50 aufgesetzt wird, greifen die Zähne der Rippen 14 jeweils zwischen die Zähne der Rippen 54, wie insbesondere auch aus Fig. 2 ersichtlich ist. Auf diese Weise wird der Zwischenkontaktträger 6 gegenüber dem Sockel 50 in einer Richtung quer zu deren Längsausrichtung exakt zentriert. In dem zwischen den Rippen 54 verbleibenden Zwischenraum, etwa im Bereich der Längssymmetrieebene des Sockels 50, sind jeweils Führungsstützen 56 angeordnet. Diese führen jeweils den mittleren Zahn jeder Rippe 14 bzw. 14′ in Längsrichtung des Sockels 50, so dass gewährleistet ist, dass sich die Profile der Rippen 14, 14′ bzw. 54 jeweils exakt ineinanderlegen. Auf diese Weise wird eine einwandfreie, lagerichtige Montage des Zwischenkontaktträgers 6 auf dem Sockel 50 zwangsläufig sichergestellt. Zwischen den Rippen 54 sind zwei parallele Reihen von zueinander parallelen Kontaktelementen 58 angeordnet, von denen der besseren Übersichtlichkeit wegen in Fig. 1d nur eines dargestellt ist. Wie insbesondere auch aus Fig. 2 hervorgeht, setzt sich jedes dieser Kontaktelemente 58 aus einem auf der Oberseite des Sockels 50 angeordneten Bügelteil 60 und einem über die Seitenkanten 62 des Sockels nach unten gebogenen, in Steckrichtung ausgerichteten Fussteil 64 zusammen. Der Bügelteil 60 der Kontaktelemente 58 ist etwa Z-förmig ausgebildet mit einem auf der Oberseite des Grundkörpers 52 aufliegenden Basisschenkel 66 sowie einem über den Verbindungsschenkel 68 damit federnd verbundenen oberen Kontaktschenkel 70. Wie insbesondere auch Fig. 4 zeigt, weist der Kontaktschenkel 70 zwei in Richtung seiner Längsausdehnung hintereinanderliegende, nach oben gewölbte Bereiche 72 und 74 auf und ist in Richtung dieser Längsausdehnung geschlitzt. Am Scheitelpunkt der gewölbten Bereiche 72, 74 sind jeweils nach aussen gerichtete, etwa halbkugelförmige Noppen 76 angeordnet. Wie Fig. 2 erkennen lässt, liegen die Kontaktlamellen 12 des Zwischenkontaktträgers 6 im montierten Zustand auf dem Kontaktschenkel 70 auf. Dabei ergeben sich entsprechend der Anzahl der Noppen 76 jeweils vier Kontaktpunkte zwischen jedem Kontaktelement 58 sowie der zugeordneten Kontaktlamelle 12.

Wie die Fig. 2 und 4 zeigen, ist am Basisschenkel 66 der Kontaktelemente 58 eine Spreizzunge 78 ausgebildet, welche sich in montiertem Zustand des Kontaktelementes 58 hinter eine im Grundkörper 52 des Sockels 50 ausgebildete Haltefläche 80 spreizt. Auf diese Weise wird das Kontaktelement 58 gegen ein Herausschieben gesichert. Ausserdem sind an den Rippen 54 des Sockels 50 jeweils seitlich abstehende Haltenasen 82 ausgebildet, welche über die Basisschenkel 66 der montierten Kontaktelemente 58 greifen und diese gegen ein Abheben desselben sichern (Fig. 2 und 3). Wie insbesondere Fig. 4 erkennen lässt, sind die Kontaktelemente 58 im Übergangsbereich vom Basisschenkel 66 zum Verbindungsschenkel 68 mit einer Einschnürung 84 versehen, welche ein Passieren dieses Übergangsbereiches zwischen jeweils zwei gegeneinander gerichteten Haltenasen 82 beim Einschieben des Kontaktelementes unter diese Haltenasen erlaubt.

An den beiden Schmalseiten des Sockels 50 sind nach oben gerichtete Führungslaschen 86, 88 ausgebildet, welche beim Aufsetzen der Haube in an dieser ausgebildete, komplementäre Führungen 90, 92 eingreifen. Die Führungslaschen 86, 88 sind federnd ausgebildet und mit Rastnasen 94, 96 versehen, welche bei auf den Sockel 50 aufgesetzter Haube 24 hinter an dieser ausgebildete Halteflächen 98, 100 greifen.

Der Zusammenbau der Einrichtung geschieht folgendermassen: Zunächst wird der IC-Träger 2 auf den Zwischenkontaktträger 6 aufgesetzt, wobei die Kontaktfüsse 4 in die Öffnungen 20 der Kontaktlamellen 12 eingreifen. Diese Baugruppe wird sodann gemäss Fig. 6 in ein Lötbad getaucht, derart, dass die Verbindungen zwischen den Kontaktfüssen 4 und den Kontaktlamellen 12 gelötet sind. Eventuell über die Unterseite des Zwischenkontaktträgers 6 vorstehende Kontaktfüsse 4 können dann abgetrennt werden. Sodann wird die aus IC-Träger 2 und Zwischenkontaktträger 6 bestehende Baugruppe in die Haube 24 eingesetzt, wo sie durch das Zusammenwirken der Haltenasen 26 und der durch die Schlitze 30 gebildeten Halteflächen festgehalten wird. Der auf diese Weise entstandene Sub-Modul wird auf den Sockel 50 aufgesetzt, wobei durch Zusammenwirken der Führungslaschen 86, 88 mit den Führungen 90, 92 eine erste gegenseitige Ausrichtung erfolgt. Bevor die Kontaktlamellen 12 mit den Kontaktelementen 58 des Sockels 50 in Berührung kommen, greifen die komplementär profilierten Rippen 14, 14′ sowie 54 ineinander, wodurch eine exakte Ausrichtung des Sub-Moduls zum Sockel 50 sichergestellt wird. Die über die Verbindungsschenkel 68 federnd gehaltenen Kontaktschenkel 70 legen sich dabei mit den Noppen 76 unter Vorspannung gegen die zugeordneten Kontaktlamellen 12, und stellen auf diese Weise einen sicheren Berührungskontakt her.

Um sicherzustellen, dass der Sub-Modul nur in einer bestimmten Lage auf den Sockel 50 aufgesetzt werden kann, können am Zwischenkontaktträger 6 sowie am Sockel 50 jeweils Codiernocken 102 bzw. 104 befestigt werden, welche eine falsche Montagelage ausschliessen (Fig. 3). Der Codiernocken 102 kann mit zwei daran ausgebildeten Haltefüssen in an den Rippen 14 bzw. 14' ausgebildete Nuten 108 eingeschoben werden. Gleichzeitig wird der zweite Codiernocken 104 mit seinen Haltefüssen 110 in an den Rippen 54 ausgebildete Nuten 112 eingeführt derart, dass sich die beiden Codiernocken 102, 104 bei der unzulässigen Montagelage genau gegenüberliegen. Die an den Codiernocken 102, 104 ausgebildeten Laschen 114, 116 kommen jeweils gegen die gegenüberliegenden Codiernocken zur Anlage und verhindern ein Aufsetzen des Zwischenkontaktträgers 6 auf den Sockel 50. Bei korrekter gegenseitiger Lage, wenn sich also keine Codiernocken gegenüberliegen, kann die Lasche 114 jeweils in Nuten 112, die Lasche 116 jeweils in Nuten 108 eingreifen, so dass ein Zusammenstecken nicht behindert wird.

Für die Herstellung des Sockels 50 ist vorgesehen, dass alle Kontaktelemente 58 einer Reihe, welche über einen Haltesteg 118 noch miteinander verbunden sind, gleichzeitig und in einem Arbeitsgang auf die Oberseite des Grundkörpers 52 und jeweils unter die Haltenasen 82 aufgeschoben werden, bis sich die Spreizungen 78 hinter den Halteflächen 80 verspreizen. Die Kontaktelemente beider Reihen können selbstverständlich in einem zusammenfallenden Arbeitsgang montiert werden. Anschliessend werden die Haltestege 118 von den Kontaktelementen 58 abgetrennt (Fig. 4).

Bei der Herstellung des Zwischenkontaktträgers 6 werden die Kontaktlamellen 12 beider Reihen in einem Arbeitsgang auf die Unterseite des Zwischenkontaktträgers aufgedrückt. Die Kontaktlamellen sind einerseits mit ihren Kontaktenden an gemeinsamen Haltestegen 120, 122 befestigt, andererseits mit ihren den Kontaktenden abgewandten Enden miteinander verbunden, wie Fig. 5 zeigt. An den Kontaktlamellen 12 sind jeweils etwa widerhakenartige Sägezahnprofile 124 ausgebildet, welche sich in das Material des Zwischenkontaktträgers eingraben und die Kontaktlamellen an ihrem Platz festhalten. Anschliessend werden in einem weiteren Arbeitsgang die Haltestange 120, 122 sowie die zwischen den Kontaktlamellen befindlichen Stege 126 abgetrennt, so dass alle Kontaktlamellen voneinander isoliert sind. Um die Stege 126 abtrennen zu können, weist der Grundkörper 8 des Zwischenkontaktträgers 6 Durchtrittsöffnungen 128 für die Trennstempel auf (Fig. 1c).

Abweichend von dem vorstehend beschriebenen Ausführungsbeispiel kann die Erfindung allgemein auch zur Steckmontage kleiner Schaltungsträger anderer Art dienen, also z.B. für Leiterplatten und sonstige Schaltungsplatinen bzw.

Schaltungsbausteine, da die beschriebene Konstruktion nicht die integrierte Schaltungstechnik voraussetzt. Der in den Figuren gezeigte IC-Träger wäre dann z.B. durch eine Platine mit diskreten Schaltelementen oder mehreren integrierten Schaltungen ersetzt.

**Patentansprüche**

1. Einrichtung für die Steckmontage eines mit Kontaktfüssen versehenen elektrischen Schaltungsträgers (2) auf einem mit Kontaktaufnahmen versehenen elektrischen Gerät, mit einem Sockel (50) aus elektrisch isolierendem Material, welcher mittels an diesem angeordneter Kontaktelemente (58) in zugeordnete Aufnahmen des Gerätes steckbar ist, ferner mit einer Haube (24), in welche der Schaltungsträger (2) vor der Steckmontage einsetzbar und in vorbestimmter Lage fixierbar ist, wobei beim Aufsetzen der den Schaltungsträger (2) aufnehmenden Haube (24) auf den Sockel (50) die Kontaktfüsse (4) des Schaltungsträgers (2) mit den Kontaktelementen (58) des Sockels (50) in elektrisch leitende Verbindung kommen, sowie mit Haltemitteln (94, 96, 98, 100) zum Fixieren der Haube (24) gegenüber dem Sockel (50) in vorbestimmter Lage, dadurch gekennzeichnet, dass der Schaltungsträger (2) auf einem Zwischenkontaktträger (6) befestigbar ist, wobei die Kontaktfüsse (4) des Schaltungsträgers (2) jeweils mit diesen zugeordneten, am Zwischenkontaktträger (6) angeordneten Zwischenkontaktlamellen (12) in Verbindung treten, welche beim Aufsetzen der aus Haube (24), Schaltungsträger (2) und Zwischenkontaktträger (6) bestehenden Baugruppe auf den Sockel (50) mit den Kontaktelementen (58) des Sockels (50) in Verbindung treten.

2. Einrichtung nach Anspruch 1, dadurch gekennzeichnet, dass die Haube (24) unmittelbar auf den Sockel (50) aufsetzbar und über die an der Haube (24) und/oder dem Sockel (50) ausgebildete Haltemittel (94, 96, 98, 100) mit diesem verbindbar ist.

3. Einrichtung nach einem der Ansprüche 1 oder 2 für Schaltungsträger mit in Steckrichtung ausgerichteten Kontaktfüssen, dadurch gekennzeichnet, dass an der in Steckrichtung unteren Seite des Schaltungsträgers (2) ein Zwischenkontaktträger (6) mit auf dessen Unterseite (10) aufliegenden, über seine Seitenränder (16, 18) hinausragenden Kontaktlamellen (12) befestigbar ist, wobei die diese Seitenränder (16, 18) übergreifenden Kontaktfüsse (4) des Schaltungsträgers (2) jeweils mit zugeordneten Kontaktlamellen (12) in elektrisch leitende Verbindung treten und dass die Kontaktlamellen (12) des Zwischenkontaktträgers (6) beim Aufsetzen auf den Sockel (50) mit zugeordneten, jeweils auf die Oberseite des Sockels (50) geführten Kontaktelementen (58) in elektrisch leitende Verbindung treten.

4. Einrichtung nach einem der Ansprüche 1 bis 3, dadurch gekennzeichnet, dass die Haube (24) auf ihrer Oberseite eine Kühlöffnung aufweist, in der türflügelartig zwischen einer diese Öffnung teilweise abdeckenden Schliessstellung und einer die Öffnung freigebenden Öffnungsstellung zumindest ein nach aussen verschwenkbarer Schwenkflügel (38, 40) angeordnet ist.

5. Einrichtung nach Anspruch 4, dadurch gekennzeichnet, dass zwei nebeneinander angeordnete Schwenkflügel (38, 40) vorgesehen sind, welche an ihren benachbarten Seitenkanten schwenkbar gelagert sind, wobei sie in ihrer Öffnungsstellung flach aneinanderliegend handgriffartig von der Oberseite der Haube abstehen.

6. Einrichtung nach einem der Ansprüche 4 oder 5, dadurch gekennzeichnet, dass die Schwenkflügel (38, 40) zumindest in ihrer Schliessstellung in wärmeleitendem Kontakt mit dem Schaltungsträger (2) stehen, dass sie aus einem Material mit hoher Wärmeleitfähigkeit bestehen, und dass sie an den in ihrer Schliessstellung nach aussen gerichteten Oberflächen mit Kühlrippen (46) versehen sind.

7. Einrichtung nach einem der Ansprüche 3 bis 6, für Schaltungsträger mit zwei parallelen Reihen von Kontaktfüssen, z.B. dual in line, dadurch gekennzeichnet, dass an der Unterseite (10) des Zwischenkontaktträgers (6) zwei nebeneinander angeordnete, parallel zu den Kontaktfussreihen verlaufende Reihen von zueinander parallelen Kontaktlamellen (12) angeordnet sind, welche an ihren über die Seitenränder (16, 18) des Zwischenkontaktträgers (6) ragenden Kontaktenden Öffnungen (20) zur Aufnahme der Kontaktfüsse (4) aufweisen, dass am Sockel (50) zwei nebeneinander angeordnete Reihen von zueinander parallelen, den zugeordneten Kontaktlamellen (12) des Zwischenkontaktträgers (6) jeweils gegenüberliegenden Kontaktelementen (58) angeordnet sind, welche sich jeweils aus einem auf der Oberseite des Sockels (50) angeordneten Bügelteil (60) und einem über die Seitenkanten (62) des Sockels (50) nach unten gebogenen, in Steckrichtung ausgerichteten Fussteil (64) zusammensetzen.

8. Einrichtung nach Anspruch 7, dadurch gekennzeichnet, dass am Zwischenkontaktträger (6) jeweils zwischen den Kontaktlamellen (12) und dass am Sockel (50) jeweils zwischen den Bügelteilen (60) Rippen (14, 14'; 54) ausgebildet sind und dass die Rippen (14, 14'; 54) des Zwischenkontaktträgers sowie des Sockels (50) jeweils komplementäre, formschlüssig ineinandergreifende Profile bilden.

9. Einrichtung nach einem der Ansprüche 7 oder 8, dadurch gekennzeichnet, dass der Bügelteil (60) der Kontaktelemente (58) des Sockels (50) jeweils etwa Z-förmig mit einem auf der Oberseite des Sockels (50) aufliegenden unteren Basisschenkel (66) sowie einem über den Verbindungsschenkel (68) federnd damit verbundenen oberen Kontaktschenkel (70) ausgebildet ist, wobei das freie Ende des Basisschenkels (66) zum Seitenrand (62) des Sockels (50) weist und in den Fussteil (64) des Kontaktelementes übergeht.

10. Einrichtung nach Anspruch 9, dadurch gekennzeichnet, dass der Kontaktschenkel (70) zwei in Richtung seiner Längsausdehnung hintereinanderliegende, nach oben gewölbte Bereiche (72, 74) aufweist und dass er in Richtung dieser Längsausdehnung geschlitzt ist.

11. Einrichtung nach Anspruch 10, dadurch gekennzeichnet, dass der Kontaktschenkel (70) etwa an den Scheitelpunkten der gewölbten Bereiche (72, 74) jeweils einen nach aussen gerichteten, etwa halbkugelförmigen Noppen (76) aufweist.

12. Einrichtung nach einem der Ansprüche 9 bis 11, dadurch gekennzeichnet, dass an den Rippen (54) des Sockels (50) jeweils seitlich abstehende, über den Basisschenkel (66) der Kontaktelemente (58) greifende Haltenasen (82) ausgebildet sind, dass die Kontaktelemente (58) im Übergangsbereich vom Basisschenkel (66) zum Verbindungsschenkel (68) eine das Passieren dieses Übergangsbereiches zwischen zwei gegeneinandergerichteten Haltenasen (82) beim Einschieben des Kontaktelementes unter diese Haltenasen erlaubende Einschnürung (84) aufweist.

13. Einrichtung nach einem der Ansprüche 9 bis 12, dadurch gekennzeichnet, dass am Basisschenkel (66) der Kontaktelemente (58) jeweils eine einer Ausschiebebewegung desselben entgegengerichtete Spreizzunge (78) ausgebildet ist, welche sich in eingeschobener Lage des Kontaktelementes (58) hinter eine am Sockel (50) ausgebildete Haltefläche (80) spreizt.

14. Einrichtung nach einem der Ansprüche 8 bis 13, dadurch gekennzeichnet, dass an den an den Rippen (14, 14') des Zwischenkontaktträgers (6) anliegenden Seitenkanten der Kontaktlamellen (12) jeweils sich in das Material der Rippen (14, 14') eingrabende Sägezahnprofile (124) ausgebildet sind.

15. Einrichtung nach einem der Ansprüche 3 bis 14, dadurch gekennzeichnet, dass an zwei gegenüberliegenden Aussenseiten des Zwischenkontaktträgers (6) Rastnasen (26) ausgebildet sind, welche beim Einsetzen desselben in die Haube (24) jeweils hinter entsprechende, an den den Aussenseiten zugeordneten Seitenwänden (28) der Haube (24) ausgebildete Halteflächen greifen.

16. Einrichtung nach einem der Ansprüche 1 bis 15, dadurch gekennzeichnet, dass an zwei gegenüberliegenden Seiten des Sockels (50) der Steckrichtung entgegengerichtete Führungslaschen (86, 88) ausgebildet sind, welche beim Aufsetzen der Haube (24) in an dieser ausgebildete, komplementäre Führungen (90, 92) eingreifen.

17. Einrichtung nach Anspruch 16, dadurch gekennzeichnet, dass die Führungslaschen (86, 88) federnd ausgebildet und mit Rastnasen (94, 96) ausgestattet sind, welche bei aufgesetzter Haube hinter an dieser ausgebildete Halteflächen (98, 100) greifen.

18. Einrichtung nach einem der Ansprüche 1 bis 17, dadurch gekennzeichnet, dass die zusammensetzbaren Einzelteile derselben jeweils in einer nur eine bestimmte gegenseitige Montagelage erlaubenden Weise profilierbar sind.

19. Einrichtung nach Anspruch 18, dadurch gekennzeichnet, dass der Sockel (50) sowie der Zwischenkontaktträger (6) jeweils eine mehrere gegenseitige Montagelagen erlaubende Form aufweisen und dass an ihnen jeweils bestimmte Montagelagen blockierende Codiernocken (102, 104) befestigbar sind.

20. Verfahren zur Herstellung einer Einrichtung gemäss den Ansprüchen 7 bis 13, dadurch gekennzeichnet, dass beim Sockel (50) die mit ihren Fussteilen an einem gemeinsamen Haltesteg (118) befestigten Kontaktelemente (58) einer Reihe gemeinsam auf die Oberseite des Sockels (50) aufgeschoben und anschliessend vom Haltesteg (118) abgetrennt werden.

21. Verfahren zur Herstellung einer Einrichtung gemäss den Ansprüchen 7 und 14, dadurch gekennzeichnet, dass beim Zwischenkontaktträger (6) die mit ihren Kontaktenden an gemeinsamen Haltestegen (120, 122) befestigten und mit den den Kontaktenden abgewandten Enden miteinander verbundenen Kontaktlamellen (12) beider Reihen gemeinsam auf die Unterseite (10) des Zwischenkontaktträgers (6) aufgedrückt werden und dass anschliessend die Kontaktlamellen (12) der beiden Reihen voneinander und von den Haltestegen (120, 122) getrennt werden.

22. Verfahren zur Herstellung einer Einrichtung gemäss den Ansprüchen 7 und 14, dadurch gekennzeichnet, dass der Schaltungsträger (2) unter Einführung seiner Kontaktfüsse (4) in die zugeordneten Öffnungen (20) der Kontaktlamellen (12) auf den Zwischenkontaktträger (6) aufgesetzt wird, und dass anschliessend die Verbindungsstellen zwischen Kontaktfüssen (4) und Kontaktlamellen (12) durch ein Lötbad geführt werden.

**Claims**

1. Apparatus for the plug-in assembling of an electric circuit carrier (2) provided with contact feet, onto an electrical appliance or the like which is provided with receptacles, with a base (50) made of electrically insulating material, which, with contact elements (58) arranged on this can be plugged into the assigned receptacles of the appliance, a cover (24), into which the circuit carrier (2) can be mounted and fixed in a predetermined position before the plug-in assembly takes place, the contact feet (4) of the circuit carrier (2) coming into electrical conducting connection with the contact elements (58) for the base (50), when the cover (24) with the circuit carrier (2) is placed on the base (50), and with holding means (94, 96, 98, 100) for fixation of the cover (24) relative to the base (50) in a predetermined position, characterized in that the circuit carrier (2) can be fixed on an intermediate contact carrier (6), the contact feet (4) of the circuit carrier (2) coming into connection respectively with assigned intermediate contact plates (12) arranged on the intermediate contact carrier (6), the contact plates (12) coming into connection with the contact elements (58) of the base (50), when the subassembly group made up of the cover (24), the circuit carrier (2) and the intermediate contact carrier (6) is placed on the base (50).

2. Apparatus as claimed in claim 1, characterized in that the cover (24) can be placed directly on the base (50) and can be connected to the base (50) by holding means (94, 96, 98, 100) being arranged on the cover (24) and/or the base (50).

3. Apparatus as claimed in claim 1 or 2 for circuit carriers with contact feet aligned in the plug-in direction, characterized in that onto the under side of the circuit carrier (2) in the plug-in direction an intermediate contact carrier (6) can be fastened with contact plates (12) situated on its under side (10) and projecting outward over its side edges (16, 18), where the contact feet (4) of the circuit carrier (2) which overlap these side edges (16, 18) respectively come into electrically conducting connection with assigned contact plates (12) and that the contact plates (12) of the intermediate contact carrier (6) when placed on the base (50) come into electrically conducting connection with assigned contact elements (58) which are respectively run on the top side of the base (50).

4. Apparatus as claimed in one of claims 1 to 3 characterized in that the cover (24) on its top side shows a cooling opening in which at least one swinging flap (38, 40) which is swingable outward is arranged in the manner of a door leaf swinging between a position partly closing the opening and an open position unblocking the opening.

5. Apparatus as claimed in claim 4, characterized in that two swinging flaps (38, 40) arranged side by side are provided which are pivoted on their adjacent side edges, wherein in their open position lying flat on one another they project out from the top side of the cover in the manner of a handle.

6. Apparatus as claimed in claim 5, characterized in that the swinging flaps (38, 40), at least in their closed position are in heat-conducting contact with the circuit carrier (2), that they consist of a material with a high thermal conductivity, and that at the surface pointing outward in their closed position thay are provided with cooling fins (46) or the like.

7. Apparatus as claimed in one of claims 3 to 6 for circuit carriers with two parallel rows of contact feet, e.g. dual in line, characterized in that on the under side (10) of the intermediate contact carrier (6) are arranged two rows of contact plates (12) parallel to one another and arranged side by side and parallel to the rows of contact feet and which on their contact ends projecting over the side edges (16, 18) of the intermediate contact carrier (6) show openings (20) for receiving the contact feet (4), in that on the base (50) are arranged two rows, arranged side by side, of contact elements (58) parallel to one another and respectively opposite the assigned contact plates (12) of the intermediate contact carrier (6), which elements are respectively composed of a loop part (60) arranged on the top side of the base (50) and a foot part (64) bent downward over the side edges (62) of the base (50) and aligned in the plug-in direction (64).

8. Apparatus as claimed in claim 7, characterized in that fins (14, 14'; 54) are formed on the intermediate contact carrier (6) respectively between the contact plates (12) and on the base (50) respectively between the loop parts (60) and that the fins (14, 14'; 54) of the intermediate contact carrier (6) and also of the base (50) respectively form complementary profiles grasping one another in a form-locking manner.

9. Apparatus as claimed in claim 7 or 8, characterized in that the loop part (60) of the contact elements (58) of the base (50) is formed respectively approximately Z-shaped with a lower bottom arm (66) lying on the top side of the base (50) as well as an upper contact arm (70) joined flexibly with this arm by way of a connecting arm (68), where the free end of the bottom arm (66) points toward the side edge (62) of the base (50) and turns into the foot part (64) of the contact element.

10. Apparatus as claimed in claim 9, characterized in that the contact arm (70) shows two regions (72, 74) arched upward and situated one behind the other in the direction of its lengthwise extension and that it is slotted in the direction of this lengthwise extension.

11. Apparatus as claimed in claim 10, characterized in that the contact arm (70) shows an outward-turned approximately hemispherical burl (76) approximately on the vertex of the curved regions (72, 74).

12. Apparatus as claimed in one of claims 9 to 11, characterized in that on the fins (54) of the base (50) respectively are formed laterally projecting holding catches (82) which grasp from above the bottom arm (66) of the contact element (58), that the contact elements (58) in the transition region from the bottom arm (66) to the connecting arm (68) show a constriction (84) making possible the passing of this transition region between two holding catches (82) turned oppositely when the contact element is inserted under these holding catches.

13. Apparatus as claimed in one of claims 9 to 12, characterized in that a spreading tongue (78) is formed on the bottom arm (66) of the contact elements and is turned counter to any pushing-out motion of the latter, which tongue spreads out behind a holding face (80) formed on the base (50) in the pushed-in position of the contact element (58).

14. Apparatus as claimed in one of claims 8 to 13, characterized in that sawtooth profiles (124) engaging into the material of the fins (14, 14') are formed on the side edges of the contact plates (12) lying against the fins (14, 14') of the intermediate contact carrier (6).

15. Apparatus as claimed in one of claims 3 to 14, characterized in that, on two opposite outer sides of the intermediate contact carrier (6), catches (26) are formed which when this is inserted in the cover (24) respectively grip behind corresponding holding surfaces formed on the side walls (28) of the cover (24) which are turned toward the outer sides.

16. Apparatus as claimed in one of claims 1 to 15, characterized in that guide plates (86, 88) turned in an opposite direction to the plug-in direction are formed on two opposite sides of the base (50) which plates engage in complementary guides (90, 92) formed on the cover (24) when the latter is placed on.

17. Apparatus as claimed in claim 16, characterized in that the guide plates (86, 88) are flexible in form and equipped with catches (94, 96) which, when the cover is placed on, grip behind on holding faces (98, 100) formed on the cover.

18. Apparatus as claimed in one of claims 1 to 17, characterized in that the individual parts of it which can be assembled may be shaped in a manner which will permit only a certain mutual assembly position.

19. Apparatus as claimed in claim 18, characterized in that the base (50) as well as the intermediate contact carrier (6) respectively show a shape permitting a plurality of mutual assembly positions and that coding lugs (102, 104) can be fastened onto them which respectively block certain assembly positions.

20. Process for fabricating an apparatus according to claims 7 to 13, characterized in that at the base (50) the contact elements (58) of one row which are fastened by their foot parts to a common holding crosspiece (118) are pushed in common onto the top side of the base (50) and then cut apart from the holding crosspiece (118).

21. Process for fabricating an apparatus according to claims 7 and 14, characterized in that at the intermediate contact carrier (6) the contact plates (12) of both rows fastened to common holding crosspieces (120, 122) by their contact ends and joined together by their ends turned away from the contact ends are pressed in common onto the under side (10) of the intermediate contact carrier (6) and that after this the contact plates (12) of the two rows are cut apart from one another and from the holding crosspieces (120, 122).

22. Process for fabricating an apparatus according to claims 7 and 14, characterized in that the circuit carrier (2), with the insertion of its contact feet (4) in the assigned openings (20) of the contact plates (12), is placed on the intermediate contact carrier (6), and that then the junction points between contact feet (4) and contact plates (12) are drawn through a soldering bath.

**Revendications**

1. Dispositif pour le montage par enfichage d'un support de circuits électriques (2) pourvu de pieds de contact sur un appareil électrique pourvu de logements de contact, comprenant un socle (50) en matière électriquement isolante, qui peut être enfiché au moyen d'éléments de contact (58) qu'il porte dans des logements correspondants de l'appareil, comprenant en outre un capot (24) dans lequel le support de circuits (2) peut être mis en place avant le montage par enfichage et être fixé à une position prédéterminée, avec lequel, lors de la pose sur le socle (50) du capot (24) contenant l'élément support de circuits (2), les pieds de contact (4) de ce support de circuits (2) viennent en liaison électriquement conductrice avec les éléments de contact (58) du socle (50), de même que des moyens de maintien (94, 96, 98, 100) pour la fixation du cappot (24) à une position détérminée par rapport au socle (50), caractérisé en ce que le support de circuits (2) peut être fixé sur un support intermédiaire de contacts (6), de sorte que les pieds de contact (4) du support de circuits électriques (2) entrent respectivement chacun en liaison avec des lamelles intermédiaires de contact (12) disposées en correspondance sur le support intermédiaire de contact (6), de sorte que, lors de la mise en place sur le socle (50) du groupe composé du capot (14), du support de circuits (2) et du support intermédiaire de contacts (6), ils entrent en liaison avec les éléments de contact (58) du socle (50).

2. Dispositif selon la revendication 1, caractérisé en ce que le capot (24) peut être monté directement sur le socle (50) et peut être assemblé avec celui-ci à l'aide des moyens de maintien (94, 96, 98, 100) prévus sur le capot (24) et/ou sur le socle (50).

3. Dispositif selon une des revendications 1 ou 2 pour un support de circuits avec pieds de contact alignés dans la direction d'enfichage, caractérisé en ce qu'un support intermédiaire de contacts (6) ayant des lamelles de contact (12) se trouvant sur sa face intérieure (10) en faisant saillie par rapport à ses bords latéraux (16, 18) peut être fixé à la face inférieure dans la direction d'enfichage du support de circuits (2), de sorte que les pieds de contact (4) du support de circuits (2) qui débordent de ces bords latéraux (16, 18) viennent en liaison électriquement conductrices respectivement avec les lamelles de contact (12) qui leur correspondent, et les lamelles de contact (12) du support intermédiaire de contacts (6) lors de sa mise en place sur le socle (50) viennent en liaison électriquement conductrice respectivement avec les éléments de contact (58) disposés sur la face supérieure du socle (50).

4. Dispositif selon une des revendications 1 à 3, caractérisé en ce que le capot (24) présente sur sa face supérieure une ouverture de refroidissement, dans laquelle est disposé, à la façon d'un battant de porte, au moins un volet pivotant (38, 40) pouvant pivoter vers l'extérieur, entre une position de fermeture où il couvre en partie cette ouverture et une position d'ouverture où il dégage cette ouverture.

5. Dispositif selon la revendication 4, caractérisé en ce qu'il est prévu deux volets pivotants (38, 40) l'un à côté de l'autre qui sont montés pivotant par des bords latéraux voisins et qui, à leur position d'ouverture, s'étendent à partir de la face supérieure du capot, en se trouvant à plat l'un contre l'autre à la manière d'une poignée.

6. Dispositif selon l'une des revendications 4 ou 5, caractérisé en ce que les volets pivotants (38, 40) se tiennent au moins à leur position de fermeture, en contact de conduction de la chaleur avec le support de circuits (2), en ce qu'ils sont réalisés en une matière à conductibilité thermique élevée et en ce qu'ils sont pourvue d'ailettes de refroidissement (46) sur leurs surfaces tournées vers l'extérieur à leur position de fermeture.

7. Dispositif selon l'une des revendications 3 à 6 pour support de circuits à deux rangées parallèles de piends de contact, par exemple à ligne binaire, caractérisé en ce qu'il est disposé sur la face inférieure (10) du support intermédiaire de contacts (6) deux rangées de lamelles de contact (12) parallèles entre elles s'étendant parallèlement aux rangées de pieds de contact, qui présentent à leurs extrémités de contact faisant saillie par rapport aux bords latéraux (16, 18) du support intermédiaire de contacts (6) des ouvertures (20) pour la réception des pieds de contact (4), et en ce qu'il est disposé sur le socle (50) deux rangées placées côte à côte d'éléments de contact (58) parallèles entre elles et respectivement situés en regard des lamelles de contact (12) du support intermédiaire de contacts (6), qui sont respectivement constitués par une partie d'étrier (60) disposée sur la face supérieure du socle (50) et par une partie de pied (64) incurvée vers le bas par-dessus les bords latéraux (62) du socle (50) et tournée dans la direction d'enfichage.

8. Dispositif selon la revendication 7, caractérisé en ce que sont prévues sur le support intermédiaire de contacts (6) des nervures (14, 14'; 54) respectivement entre les lamelles de contact (12) ainsi que sur le socle (50), respectivement entre les parties d'étrier (60), les nervures (14, 14', 54) du support intermédiaire de contacts ainsi que du socle (50) ayant respectivement des profils complémentaires s'accrochant les uns aux autres par encastrement de forme.

9. Dispositif selon une des revendications 7 ou 8, caractérisé en ce que la partie d'étrier (60) des éléments de contact (58) du socle (50) a approximativement la configuration d'un Z avec une branche inférieure de base (66) reposant sur la face supérieure du socle (50) et une branche supérieure de contact (70) à laquelle elle est reliée élastiquement par une branche de raccordement (68), de telle sorte que l'extrémité libre de la branche de base (66) est tournée vers le bord latéral du socle (50) et est prolongée par la partie de pied (64) de l'élément de contact.

10. Dispositif selon la revendication 9, caractérisé en ce que la branche de contact (70) présente deux parties (72, 74) incurvées vers le haut se suivant l'une derrière l'autre dans le sens de son extension longitudinale et en ce qu'elle est fendue dans le sens de cette extension longitudinale.

11. Dispositif selon la revendication 10, caractérisé en ce que la branche de contact (70) présente à proximité de chacun des points constituant les sommets des parties incurvées (72, 74) des boutons (76) de configuration approximativement hémisphérique tournés vers l'extérieur.

12. Dispositif selon une des revendications 9 à 11, caractérisé en ce que sont prévus sur les nervures (54) du socle (50) des talons de retenue (82) qui s'écartent latéralement et saisissent respectivement les branches de base (66) des éléments de contact (58), et en ce que les éléments de contact (58) présentent, dans la partie de transition entre la branche de base (66) et la branche de raccordement (68), un rétrécissement (84) permettant le passage de cette partie de transition entre deux talons de retenue (82) tournés l'un vers l'autre, au moment de l'engagement de l'élément de contact sous ces talons de retenue.

13. Dispositif selon l'une des revendications 9 à 12, caractérisé en ce qu'il est prévu respectivement sur la branche de base (66) des éléments de contact (58) une languette écartée (78) orientée dans le sens opposé au mouvement de dégagement de celle-ci et qui, à l'état d'engagement de l'élément de contact (58), s'écarte en arrière d'une surface d'arrêt (80) prévue sur le socle (50).

14. Dispositif selon l'une des revendications 8 à 13, caractérisé en ce que sur les bords latéraux des lamelles de contact (12) qui viennent en contact avec les nervures (14, 14') du support intermédiaire de contacts (6) sont réalisés respectivement des profils en dents de scie (124) s'enfonçant dans la matière des nervures (14, 14').

15. Dispositif selon l'une des revendications 3 à 14, caractérisé en ce que sont prévus sur deux bords extérieurs opposés du support de contacts intermédiaire (6) des talons d'arrêt (26) qui, lors de la mise en place de celui-ci dans le capot (24), coopèrent respectivement avec des surfaces d'arrêt situées sur des parois latérales (28) correspondantes disposées vers l'extérieur du capot (24).

16. Dispositif selon l'une des revendications 1 à 15, caractérisé en ce qu'il est prévu sur deux côtés opposés du socle (50) des flasques de guidage (86, 88) dirigés dans le sens opposé de la direction d'enfichage, et qui, lors de la mise en place du capot (24), s'engagent dans des glissières de guidage complémentaires (90, 92) ménagées sur ce dernier.

17. Dispositif selon la revendication 16, caractérisé en ce que les flasques de guidage (86, 88) ont une constitution élastique et sont munies de talons d'arrêt (94, 96) qui, lors de la mise en place du capot, s'engagent avec des surfaces d'arrêt (98, 100) prévues sur ce dernier.

18. Dispositif selon l'une des revendications 1 à 17, caractérisé en ce que les pièces individuelles assemblables de ce dispositif peuvent être profilées d'une manière autorisant seulement une position de montage mutuel déterminée.

19. Dispositif selon la revendication 18, caractérisé en ce que le socle (50) et le support intermédiaire de contacts (6) présentent une forme permettant plusieurs positions de montage mutuel et en ce que des plots de codage (102, 104) bloquant des positions de montage déterminés peuvent y être fixés.

20. Procédé de fabrication d'un dispositif selon les revendications 7 à 13, caractérisé en ce que pour un socle (50) les éléments de contacts (58) d'une rangée, fixés par leur partie de pied à une barrette de maintien commune, sont engagés ensemble sur la face supérieure du socle (50), puis sont séparés de la barrette de maintien (118).

21. Procédé de fabrication d'un dispositif selon les revendications 7 à 14, caractérisé en ce que pour un support intermédiaire de contacts (6), les lamelles de contact (12) des deux rangées, fixées par leurs extrémités de contact à des barrettes de maintien communes (120, 122) et reliées les unes aux autres par leurs extrémités opposées aux extrémités de contact sont appliquées ensemble sur la face inférieure (10) du support intermédiaire de contacts et ensuite les lamelles de contact (12) sont séparées les unes des autres ainsi que des barrettes de maintien (120, 122).

22. Procédé de fabrication d'un dispositif selon les revendications 7 et 14, caractérisé en ce que le support de circuit (2) est mis en place par l'introduction de ses pieds de contact (4) dans les ouvertures (20) correspondantes des lamelles de contact (12) sur le support intermédiaire de contacts (6) et ensuite les points de liaison entre les pieds de contact (4) et les lamelles de contact (12) sont réalisés au moyen d'un bain de soudure.

Fig.1A

Fig.1B

Fig.1C

Fig.1D

0 116 162

Fig.2

Fig. 3

15

Fig. 4

Fig. 5

Fig. 6